# EUROPÄISCHE PATENTSCHRIFT

(11) **EP 1 511 094 B1**
(45) Veröffentlichungstag und Bekanntmachung des Hinweises auf die Patenterteilung: **22.02.2017**
(21) Anmeldenummer: 04018867.4
(22) Anmeldetag: 10.08.2004
(51) Int. Cl.: H01L 51/50, H01L 51/54

(54) **Licht emittierendes Bauelement und Verfahren zu seiner Herstellung**
Light emitting device and method of fabrication
Dispositif électroluminescent et méthode de fabrication

(30) Priorität: 27.08.2003 DE 10339772
(43) Veröffentlichungstag der Anmeldung: 02.03.2005
(73) Patentinhaber: Novaled GmbH, 01307 Dresden (DE)
(72) Erfinder: Blochwitz-Nimoth, Jan, Dr., 01097 Dresden (DE); Sorin, Gildas, 01099 Dresden (DE)
(74) Vertreter: Bittner, Thomas L.

(56) Entgegenhaltungen:
- WO-A-03/044829
- US-A1- 2003 020 073
- US-A1- 2003 111 666
- ZHOU X ET AL: "Low-voltage inverted transparent vacuum deposited organic light-emitting diodes using electrical doping" APPLIED PHYSICS LETTERS AIP USA, Bd. 81, Nr. 5, 29. Juli 2002 (2002-07-29), Seiten 922-924, XP001133200 ISSN: 0003-6951
- PFEIFFER M ET AL: "INVITED PAPER: OLEDS WITH DOPED TRANSPORT LAYERS FOR HIGHLY EFFICIENT DISPLAYS" 2003 SID INTERNATIONAL SYMPOSIUM DIGEST OF TECHNICAL PAPERS. BALTIMORE, MD, MAY 20 - 22, 2003, SID INTERNATIONAL SYMPOSIUM DIGEST OF TECHNICAL PAPERS, SAN JOSE, CA : SID, US, Bd. VOL. 34 / 2, 20. Mai 2003 (2003-05-20), Seiten 1076-1079, XP001174226
- COTTON F A ET AL: "Closed-shell molecules that ionize more readily than cesium" SCIENCE AMERICAN ASSOC. ADV. SCI USA, Bd. 298, Nr. 5600, 6. Dezember 2002 (2002-12-06), Seiten 1971-1974, XP002330163 ISSN: 0036-8075
- WERNER A G ET AL: "Pyronin B as a donor for n-type doping of organic thin films" APPLIED PHYSICS LETTERS, AMERICAN INSTITUTE OF PHYSICS. NEW YORK, US, Bd. 82, Nr. 25, 23. Juni 2003 (2003-06-23), Seiten 4495-4497, XP012034443 ISSN: 0003-6951
- J. BLOCHWITZ: 'Organic light-emitting diodes with doped charge transport layers', [Online] 2001, Dresden, Dissertation Gefunden im Internet: <URL:http://www.qucosa.de/fileadmin/data/qu cosa/documents/1582/997196106312-4249.pdf>
- Micaroni L. ET AL: "Considerations about the electrochemical estimation of the ionization potential of conducting polymers", Journal of solid state electrochemistry, vol. 7, no. 1, 1 December 2002 (2002-12-01), pages 55-59, XP055062763, ISSN: 1432-8488, DOI: 10.1007/s10008-002-0289-0

## Beschreibung

Die Erfindung betrifft ein Licht emittierendes Bauelement mit organischen Schichten, insbesondere eine organische Leuchtdiode, bestehend aus mehreren Schichten zwischen einem Grundkontakt auf einem Substrat und einem Deckkontakt, mit als Polymerschicht, die aus Polymer besteht, ausgebildeten Schichten und mit als Molekülschicht ausgebildeten Schichten, die aus im Vakuum aufgebrachten kleinen Molekülen bestehen.

Die Erfindung betrifft auch ein Verfahren zur Herstellung eines Licht emittierenden Bauelementes, bei dem auf ein Substrat ein Grundkontakt, danach mehrere Schichten und schließlich ein Deckkontakt aufgebracht wird.

Organische Leuchtdioden sind seit der Demonstration niedriger Arbeitsspannungen von Tang et al. 1987 [C.W. Tang et al., Appl. Phys. Lett. 51 (12), 913 (1987)] aussichtsreiche Kandidaten für die Realisierung großflächiger Displays und anderer Anwendungen, wie z.B. Beleuchtungselemente. Sie bestehen aus einer Reihenfolge dünner (typischerweise 1nm bis 1µm) Schichten aus organischen Materialien, welche bevorzugt im Vakuum in Form kleiner Moleküle aufgedampft werden, wodurch sogenannte OLED erzeugt werden, oder aus Lösung aufgeschleudert, gedruckt oder in anderer geeigneter Form aufgebracht werden (Polymere), wodurch sogenannte PLED erzeugt werden. Durch die Injektion von Ladungsträgern (Elektronen von der einen, Löcher von der anderen Seite) aus den Kontakten in die dazwischen befindlichen organischen Schichten infolge einer äußeren angelegten Spannung, der folgenden Bildung von Exzitonen (Elektron-Loch-Paaren) in einer aktiven Zone und der strahlenden Rekombination dieser Exzitonen, wird Licht erzeugt und von der Leuchtdiode emittiert.

Üblicher Weise liegt organischen Leuchtdioden in Form von PLED folgende Schichtstruktur zugrunde:
1. Substrat (transparent, z.B. Glas)
2. Anode (transparent, meistens Indium Zinn Oxid (ITO))
3. Löchertransport- oder Löcherinjektionsschicht (meistens PEDOT:PSS oder PANI - polyanilin mit Beimischungen wie PSS; PEDOT = polyethylenedioxythiophene, PSS = polystyrenesulfonate)
4. aktives Polymer (emittiert Licht)
5. Kathode (meist ein Metall mit niedriger Austrittsarbeit wie Barium, Calcium)

Die polymeren Schichten, d.h. die Löchertransport- oder Löcherinjektionsschicht und das aktive Polymer werden aus einer flüssigen Lösung (in Wasser oder in Lösungsmitteln) hergestellt. Die Kontakte (Anode, Kathode) typischerweise durch Vakuumprozessen.

Die Vorteile dieser Struktur für Anwendungen, z.B. Displays ist die Vielfältigkeit der Prozesse zur Herstellung der polymeren Schichten, darunter solche Prozesse, die eine einfache laterale Strukturierung der PLED erlauben, namentlich das Tintenstrahl(Ink-Jet)-Drucken. Bei diesem werden die unterschiedlichen Polymere der drei Farben auf vorher vorbereitete Stellen gedruckt, wodurch nebeneinanderliegende Bereiche verschiedener Emissionsfarbe entstehen.

Der Nachteil besteht unter anderem darin, dass nicht sinnvoll mehr als zwei verschiedene polymere Schichten aufgetragen werden können, da die Lösungsmittel der Polymere so gewählt werden müssen, dass sie sich gegenseitig nicht beeinflussen, das heißt das Material der Unterlage nicht angreifen. Dies bedeutet, dass das emittierende Polymer gleichzeitig auch gut zum Elektronentransport und zur Elektroneninjektion aus der Kathode geeignet sein muss, eine Forderung, die starke Einschränkung für die Materialauswahl und die Strukturoptimierung darstellt.

Hinzu kommt, dass man die Reihenfolge der Struktur für ein gegebenes Materialsystem nur schwer ändern kann, also dass wie im obigen Fall mit der Anode angefangen werden muss. Dies ist insbesondere für die Integration der PLED auf Aktiv-Matrix Display-Substraten mit n-Kanal Transistoren als Schaltelement nachteilig. Die Verwendung transparenter Deckkontakte (auch als Kathode) ist ebenso schwierig, da diese meistens durch einen Sputterprozess hergestellt werden (z.B. ITO). Dieser zerstört aber organische Materialien. Da die oberste Schicht in einer PLED eine emittierende Schicht ist, wird die Effizienz der Lichterzeugung der organischen Leuchtdiode dadurch gesenkt. Eine Verbesserung der Stabilität gegen Sputterschäden kann durch das Einbringen einer im Vakuum aufgedampften Schicht aus kleinen Molekülen erreicht werden. Allerdings stellt auch in diesem Fall die Elektroneninjektion aus der Kathode ein Problem dar. Ein weiterer Nachteil der obigen Struktur ist es, dass man nur mit sehr instabilen Kontaktmaterialien wie Barium oder Kalzium eine effiziente Elektroneninjektion erreichen kann. Diese Materialien werden aber von Sauerstoff und Wasser angegriffen.

Organische Leuchtdioden in Form von OLEDs werden aus in Vakuum aufgedampfte kleinen Molekülen aufgebaut. Sind die Moleküle, welche die Schichten der OLED bilden sollen, klein genug, so können sie meistens ohne Zersetzung durch einen thermischen Prozess aufgebracht werden. Dazu werden die Moleküle im Vakuum (wegen der großen freien Weglänge) verdampft.

Um die Injektion aus den Kontakten in die organische Schicht zu verbessern und die Leitfähigkeit der Transportschichten zu erhöhen, können die Transportschichten durch Mischverdampfung mit organischen oder anorganischen Dotanden, welche Akzeptoren (für Löcherdotierung) bzw. Donatoren (für Elektronendotierung) sind, dotiert werden. Dabei müssen die Dotanden am Beginn des Verdampfungsprozesses nicht in ihrer endgültigen Form vorliegen, solange das alternativ verwendete Precursor-Material beim Verdampfungsprozess (der auch modifiziert sein kann, z.B. durch Benutzung von Elektronenstrahlen) den Dotanden bildet. Die Herstellung der gemischten Schichten erfolgt typischerweise durch Misch (Ko-)verdampfung.

Zusätzlich zu den dotierten Transportschichten müssen dann noch intrinsische (also nicht dotierte) Zwischenschichten mit bestimmten energetischen Eigenschaften eingebracht werden (Patent DE 100 58 578, M. Pfeiffer et al. "Lichtemittierendes Bauelement mit organischen Schichten", eingereicht am 20.11.2000; X. Zhou et al., Appl. Phys. Lett. 78, 410 (2001)).

Die Struktur der OLED ist dann eine pin-Heterostruktur:
1. Träger, Substrat,
2. Elektrode, löcherinjizierend (Anode = Pluspol), vorzugsweise transparent,
3. p-dotierte Löcher injizierende und transportierende Schicht,
4. dünnere löcherseitige Blockschicht aus einem Material dessen Bandlagen zu den Bandlagen der sie umgebenden Schichten passt,
5. lichtemittierende Schicht,
6. elektronenseitige Blockschicht (typischerweise dünner als die nachfolgend genannte Schicht) aus einem Material, dessen Bandlagen zu den Bandlagen der sie umgebenden Schichten passt,
7. n-dotierte Elektronen injizierende und transportierende Schicht,
8. Elektrode, meist ein Metall mit niedriger Austrittsarbeit, elektroneninjizierend (Kathode = Minuspol)

Vorteile dieser Struktur sind die getrennte Optimierbarkeit der Eigenschaften der einzelnen Schichten, der einstellbare große Abstand der Emitterschicht zu den Kontakten, die sehr gute Injektion der Ladungsträger in die organischen Schichten und die geringe Dicke der nicht gut leitfähigen Schichten (4; 5; 6). Damit lassen sich sehr niedrige Betriebsspannungen (<2,6V für 100cd/m2 Leuchtdichte) bei gleichzeitig hoher Effizienz der Lichterzeugung erreichen, wie dies in J. Huang, M. Pfeiffer, A. Werner, J. Blochwitz, Sh. Liu, K. Leo , Appl. Phys. Lett., 80, 139-141 (2002): Low-voltage organic electroluminescent devices using pin structures, beschrieben ist. Wie in der DE 101 35 513.0 und in X.Q Zhou et al., Appl. Phys. Lett. 81, 922 (2002) dargestellt, lässt sich diese Struktur außerdem auch leicht invertieren und sich top-emittierende oder ganz transparente OLEDs realisieren, wie in der DE 102 15 210.1 beschrieben.

Der Nachteil dieser Struktur besteht darin, dass eine laterale Strukturierung der OLED-Struktur zum Aufbau verschiedenfarbiger Pixel in einem Display nur über Schattenmasken erfolgen kann. Dieser Prozess hat Limitationen hinsichtlich der kleinsten erreichbaren Pixelgrößen (<50µm Subpixel). Der Schattenmaskenprozess ist in einer Fertigung ein relativ aufwendiger Prozess. Allerdings kann man den Ink-Jet Prozess bei kleinen Molekülen wegen ihrer Unlöslichkeit nicht anwenden.

In der US 2003/020073A1 wird die Verwendung von aufgedampften Blockschichten und Elektronentransportschichten auf einer polymeren Löchertransportschicht beschrieben. Bei dieser Anordnung besteht die Möglichkeit, die polymere Schicht lateral zu strukturieren, um ein Vollfarbdisplay herzustellen. Allerdings ist bei dieser Anordnung die Injektion von Ladungsträgern (hier Elektronen von der Kathode in die molekulare Elektronentransportschicht) problematisch, was die Betriebsspannung der hybriden polymer-small molecule OLED erhöht.

Aus US 2003/111666 ist ein Licht emittierendes Bauelement mit organischen Schichten bekannt, welches aus mehreren Schichten zwischen einem Grundkontakt und einem Deckkontakt besteht. Hierbei sind Polymerschichten und Molekülschichten vorgesehen.

Dem Artikel "OLEDs with doped transport layers for highly efficient displays" von Pfeiffer et al. sind verschiedene Dotierungsmöglichkeiten in organischen Leuchtdioden zu entnehmen. Der Artikel "Closed-shell molecules that ionize more readily than cesium" von Cotton et al. beschreibt stabile Moleküle mit einem niedrigen Ionisationspotential.

In dem Artikel "Pyronin B as a donor for n-typed doping of organic thin films" von Werner et al. wird die Verwendung von Pyronin B als ein Donator in dünnen organischen Schichten beschrieben.

Der Artikel "Low-voltage inverted transparent vacuum deposited organic light-emitting diodes using electric doping" von Zhou et al. beschreibt die Vorteile einer elektrischen Dotierung in transparenten invertierten organischen Leuchtdioden.

Es ist somit Aufgabe der Erfindung, die Flexibilität des Aufbaus eines Licht emittierenden Bauelementes und die Injektion von Ladungsträgern in die organischen Schichten unter Beibehaltung einer guten Strukturierbarkeit zu erhöhen.

Diese Aufgabe wird durch ein Licht emittierendes Bauelement nach dem unabhängigen Patentauspruch 1 und ein Verfahren nach dem unabhängigen Patentanspruch 22 gelöst. Vorteilhafte Ausgestaltungen der Erfindung sind gegenstand von abhängigen Unteransprüchen.

Der Dotand soll aus einem organischen oder metall-organischen Molekül bestehen, welches eine molare Masse von größer 200g/mol bevorzugt größer 400g/mol aufweist. Dabei kommt es darauf an, dass der in der Schicht aktive Dotand diese molare Masse aufweist. Beispielsweise ist Cs₂CO₃ (Cäsiumcarbonat, molare Masse ca. 324g/mol) als Donator für die n-Dotierung der Elektronentransportschicht im Sinne der Erfindung nicht geeignet. Cs₂CO₃ als solches ist eine vergleichsweise stabile Verbindung, welche nicht mehr in der Lage ist, ein oder mehr Elektronen auf ein anderes Molekül (das Matrixmaterial) zu übertragen. Allerdings kann in einem Bedampfungsprozess oberhalb 615°C (Zersetzungstemperatur) molekulares Cs freigesetzt werde, welches in der Lage wäre, als Dotand ein Elektron auf das Matrixmaterial zu übertragen. Die molare Masse von Cs liegt aber bei ca. 132g/mol. Cäsium hat als Dotand den Nachteil, als relativ kleines Molekül bzw. Atom nicht diffussionsstabil in der Matrixschicht eingebaut zu werden, mit negativen Einflüssen auf die Lebensdauer des organischen lichtemittierenden Bauelementes. Sinngemäßes gilt im Falle der p-Dotierung der Löchertransportschicht mit einem starken Akzeptor (beim invertiertem POLED-Aufbau).

Die beiden molekularen aufgedampften Schichten sind die undotierte Zwischenschicht (Bezugsziffer 5 in dem nachfolgend beschriebenen Ausführungsbeispiel) und die dotierte Transportschicht. Da die energetische Barriere der Ladungsträgerinjektion von der dotierten Transportschicht in die polymer Emitterschicht für gebräuchliche Emitterpolymere wie Poly-phenylenvinylen, PPV, (im Falle der herkömmlich bekannten Schichtstruktur mit polymer Löchertransportschicht auf einem Substrat die Barriere zur Injektion der Elektronen) zu groß ist, muss eine undotierte Zwischenschicht eingefügt werden, welche wesentlich dünner als die dotierte Transportschicht ist und deren LUMO Energieniveau (LUMO: niedrigstes unbesetztes Molekülorbital) im Falle der Löchertransportschicht allerdings das HOMO Energieniveau (HOMO: höchstes besetztes Molekülorbital) zwischen der dotierten Transportschicht und der Emissionspolymerschicht liegen muss. Das hat zum einen die Folge, dass einerseits Ladungsträger besser in die Emitterpolymerschicht injiziert werden können, andererseits auch nicht-strahlende Rekombinationsprozesse an der Grenzfläche von der Emitterpolymerschicht zur der dotierten Transportschicht auftreten, wobei üblicherweise diese bei hohen energetischen Barrieren nahezu zwangsläufig auftreten.

Vorteilhafterweise erfolgt die Dotierung der Molekülschicht in einem Vakuum aus zwei separat geregelten Quellen als eine Mischverdampfung.

Der Auftrag der Polymerschichten kann dabei mit einfachen Mitteln sehr präzise erfolgen. Diese Strukturierung dient dann gleichzeitig der Strukturierung des späteren Licht emittierenden Bauelementes, ohne dass aufwändige Strukturierungsschritte oder -mittel erforderlich sind. Die Aufbringung von Molekülschichten hingegen vermeidet es, dass in Folge des Vorhandenseins von in der Regel nur zwei disjunkten Lösungsmitteln die Modifikation von Polymerschichten sehr beschränkt ist und erhöht die Möglichkeit des Aufbaues verschiedenster Schichtkombinationen.

Die Erfindung soll nachfolgend anhand eines Ausführungsbeispieles näher erläutert werden.

In den zugehörigen Zeichnungen zeigt
- Fig. 1: einen ersten Schichtaufbau einer erfindungsgemäßen organischen Leuchtdiode,
- Fig. 2: einen zweiten, zur Fig. 1 elektrisch inversen Schichtaufbau einer organischen Leuchtdiode.

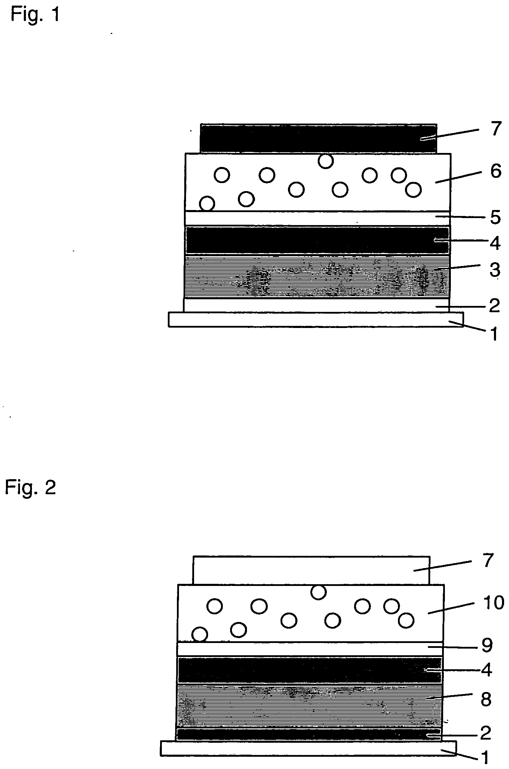

Wie in Fig. 1 dargestellt, ist auf einem Substrat 1 eine transparente Grundkontakt 2 als Anode aufgebracht. Auf diesem Grundkontakt 2 ist eine erste Polymerschicht als polymere Löchertransportschicht 3 und eine zweite Polymerschicht als polymere Emitterschicht 4 abgeschieden. Dieser Schichtverbund aus erster und zweiter Polymerschicht besteht aus PEDOT:PSS (Baytron-P) von H.C.Starck, Deutschland. Darauf ist eine erste Molekülschicht als Zwischenschicht 5 aufgedampft, die aus einer Schicht von 10nm BPhen (Batophenanthrolin) besteht. Darauf befindet sich eine zweite Molekülschicht in Form einer Elektronentransport- und Injektionsschicht 6 aus BPhen:Cs (molare Dotierungskonzentration ca. 10:1 bis 1:1). Schließlich ist die organische Leuchtdiode gemäß Fig.1 mit einem Deckkontakt 7 aus Aluminium versehen.

Molekulares Cs ist in diesem Zusammenhang als ein nicht zweckmäßiger Elektronen abgebender Dotand anzusehen, da Cs eine zu kleine molare Masse aufweist, um damit eine diffussionstabile dotierte Schicht erzielen zu können. Vorgesehen sind daher Dotiermaterialien mit einer molaren Masse größer 200 g/mol, bevorzugt größer 400 g/mol, und ein Redoxpotential im Bereich von Cs aufweisen. Cs hat ein Standardredoxpotential von -2,922 V und eine Ionisationsenergie von 3,88 eV. Die Ionisationsenergie des Dotanden ist kleiner als 4,1 eV.

Ein Beispiel für einen dieser Dotanden ist Wolfram-Paddlewheel [W₂(hpp)₄] :

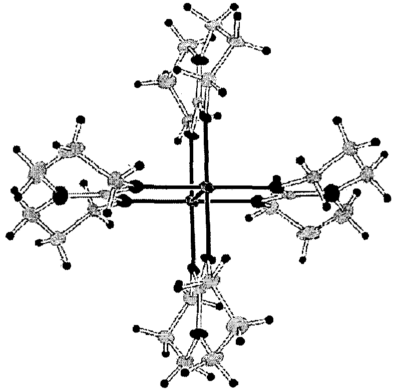

Wolfram-Paddlewheel hat ein Ionisationspotential von ca. 3,75 eV. Die Struktur des einfach negativen hpp-Anions lautet:

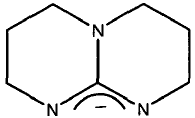

Aus Vergleichen mit dem Gas-Ionisationspotentiale von molekularem Cs von 3,9 eV und der Elektronenaffinität von BPhen als Schicht von ca. 2,4eV kann man abschätzen, dass es erforderlich ist, dass der Donator-Dotand für OLED-Transportmaterialien ein Ionisationspotential von kleiner als 4,1eV aufweist.

Die dotierte Schicht (im obigen bsp. BPhen:Cs) muss eine Leitfähigkeit im Bereich 1E-7 S/cm bis 1E-3S/cm, bevorzugt in einem Bereich von 1E-6S/cm bis 5E-5S/cm, aufweisen. Die Leitfähigkeit der undotierten Zwischenschicht (im obigen Bsp. BPhen) muss in einem Bereich von ca. 1E-10S/cm bis 5E-8S/cm liegen. Die Leitfähigkeit der undotierten Schicht ist also wenigstens eine halbe Größenordnung schlechter als die der dotierten Schicht. Die bevorzugten Dickenbereiche der dotierten Schicht liegen zwischen 40 nm und 500 nm, bevorzugt 50 nm bis 300 nm, die der undotierten Zwischenschicht zwischen 2 nm und 30 nm, bevorzugt zwischen 5 nm und 15 nm. Die undotierte Schicht muss wegen ihrer geringen Leitfähigkeit wesentlich dünner als die dotierte Schicht sein. Die Betrachtungen hinsichtlich Schichtdicke und Leitfähigkeit gelten sinngemäß auch für die p-Dotierung der Löchertransportschicht nach dem weiter unten folgenden Ausführungsbeispiel 2.

Diese Ausführungsform kann dadurch modifiziert werden, dass als polymere Löchertransportschicht 3 und als polymere Emitterschicht 4 eine einzige Schicht auftreten kann, die beide Funktionen übernimmt, mithin also nur eine Polymerschicht vorhanden sein kann. Des Weiteren kann der Grundkontakt 2 auch nichttransparent ausgebildet sein (z.B. Gold, Aluminium) und dann den Deckkontakt 7 als Kathode transparent, z.B. durch eine in einem Sputterprozess hergestellte ITO-Schicht. Wegen der Dotierung der Schicht 6 ist eine Elektroneninjektion von ITO in Schicht 6 immer noch möglich. Ferner kann die Dotanden-Konzentration im Falle organischer Dotanden zwischen 1:1000 und 1:20 liegen.

Wie ersichtlich, besteht die erfindungsgemäße organische Leuchtdiode sowohl aus Polymer- wie auch aus Molekülschichten und kann deshalb sinnvoll auch als POLED oder hybride OLED bezeichnet werden.

Eine alternative Ausführungsform, nicht Teil der Erfindung, ist in Fig. 2 dargestellt. Sie zeigt einen zu Fig. 1 elektrisch inversen Aufbau. Auf einem Substrat 1 ist ein Grundkontakt 2 als Kathode aufgebracht. Der Grundkontakt 2 ist als nicht-transparente Kathode (Calzium, Barium oder Aluminium) ausgeführt, kann aber auch transparent sein (ITO). Auf diesem Grundkontakt 2 ist eine erste Polymerschicht als polymere Elektronentransportschicht 8 und eine zweite Polymerschicht als polymere Emitterschicht 4 abgeschieden. Darauf ist eine erste Molekülschicht als Zwischenschicht 9 aufgedampft, die aus einer Schicht von 10nm TPD (tri-phenyldiamin) bestehen kann. Darauf befindet sich eine zweite Molekülschicht in Form einer Löchertransport- und Injektionsschicht 10 aus z.B. m-MTDATA dotiert mit F4-TCNQ (tris(3-methylphenylphenylamino)-triphenylamine dotiert mit Tetrafluoro-tetracyanoquinodimethane) im molaren Verhältnis ca. 50:1. Schließlich ist die organische Leuchtdiode gemäß Fig. 2 mit einer Anode als Deckkontakt 7 aus z.B. transparentem ITO versehen.

Weitere nicht näher dargestellte Ausführungsformen, nicht Teil der Erfindung, bestehen
darin, die Reihenfolge der Polymer- und Molekülschichten zu vertauschen, dass heißt, erst auf das Substrat 1 dem Grundkontakt 2 eine dotierte Molekülschicht 10 oder 6 aufzubringen, und im Anschluss daran die lateral strukturierbaren Polymerschichten 4 und 8 oder 3 aufzubringen. Weiterhin alternativ dazu ist eine Ausführung möglich, bei der eine aktive polymer Emitterschicht 4 von organischen Molekülschichten umrahmt wird.

Ist auf dem Substrat 1 eine Anode als Grundkontakt 2 aufgebracht, so ist die
anschließende Reihenfolge molekulare dotierte Löcherinjektions- und -transportschicht 10, Zwischenschicht 9, polymere Schicht 4, Zwischenschicht 5 und molekulare dotierte Elektronentransportschicht 10 und Deckkontakt 7 als Kathode. Ist die Kathode als Grundkontakt 2 auf dem Substrat 1 aufgebracht, so ist die Reihenfolge invertiert.

### Bezugszeichenliste

- 1: Substrat
- 2: Grundkontakt
- 3: polymere Löchertransportschicht
- 4: polymere Emitterschicht
- 5: Zwischenschicht (Molekülschicht)
- 6: dotierte Elektronentransport- und Injektionsschicht (Molekülschicht)
- 7: Deckkontakt
- 8: polymere Elektronentransportschicht
- 9: Zwischenschicht (Molekülschicht)
- 10: dotierte Löchertransport- und Injektionsschicht (Molekülschicht)

## Patentansprüche

1. Licht emittierendes Bauelement mit organischen Schichten, bestehend aus mehreren Schichten zwischen einem Grundkontakt auf einem Substrat und einem Deckkontakt, mit Polymerschichten aus Polymer und mit Molekülschichten aus im Vakuum aufgebrachten kleinen Molekülen, wobei wenigstens eine Polymerschicht (3; 4) und zwei Molekülschichten (5; 6) angeordnet sind, wobei
- der Deckkontakt (7) eine Kathode ist und die dem Deckkontakt (7) nächstliegende Schicht als eine Elektronen transportierende Molekülschicht ausgebildet ist und mit einem organischen Donatormaterial n-dotiert ist, wobei die n-dotierte Molekülschicht eine ein Matrixmaterial bildende, organische Hauptsubstanz und das Donatormaterial umfasst, **dadurch gekennzeichnet, dass** das Donatormaterial ein Ionisationspotential von kleiner als 4,1eV hat und die molekulare Masse des Donatormaterials größer 200g/mol ist.

2. Licht emittierendes Bauelement nach Anspruch 1, **dadurch gekennzeichnet, dass** eine Polymerschicht angeordnet ist, die gleichzeitig eine Emitter- und eine Transportschicht bildet.

3. Licht emittierendes Bauelement nach Anspruch 1 oder 2, **dadurch gekennzeichnet, dass** mehr als zwei Polymerschichten (3; 4) angeordnet sind.

4. Licht emittierendes Bauelement nach einem der Ansprüche 1 bis 3, **dadurch gekennzeichnet, dass** nur eine Molekülschicht angeordnet ist, die dotiert ist.

5. Licht emittierendes Bauelement nach einem der Ansprüche 1 bis 3, **dadurch gekennzeichnet, dass** das Matrixmaterial der dotierten Molekülschicht (9) gleich einem Matrixmaterial einer undotierten Zwischenschicht (5) ist.

6. Licht emittierendes Bauelement nach einem der Ansprüche 1 bis 5, **dadurch gekennzeichnet, dass** auf dem Grundkontakt (2) eine oder mehrere dotierte oder undotierte Molekülschichten und auf deren dem Grundkontakt (2) abgewandten Seite eine oder mehrere Polymerschichten angeordnet sind.

7. Licht emittierendes Bauelement nach einem der Ansprüche 1 oder 2, **dadurch gekennzeichnet, dass** eine Polymerschicht angeordnet ist, an die sowohl auf ihrer dem Grundkontakt (2) zugewandten Seite als auch auf ihrer dem Deckkontakt (7) zugewandten Seite je eine Molekülschicht angrenzt.

8. Licht emittierendes Bauelement nach einem der Ansprüche 1 bis 7, **dadurch gekennzeichnet, dass** der Deckkontakt (7) und der Grundkontakt (2) transparent ausgebildet sind.

9. Licht emittierendes Bauelement nach einem der Ansprüche 1 bis 8, **dadurch gekennzeichnet, dass** es aus einer Mehrfachanordnung gleicher Licht emittierender Bauelemente besteht, die miteinander mittels einer Verbindungsschicht elektrisch miteinander verbunden sind.

10. Licht emittierendes Bauelement nach Anspruch 9, **dadurch gekennzeichnet, dass** die Verbindungsschicht mit einem Kontakt versehen ist und über diesen ansteuerbar ist.

11. Licht emittierendes Bauelement nach Anspruch 9 oder 10, **dadurch gekennzeichnet, dass** die Verbindungsschicht und/oder der Kontakt transparent ausgeführt sind.

12. Licht emittierendes Bauelement nach einem der Ansprüche 1 bis 11, **dadurch gekennzeichnet, dass** der Donator-Dotand in der Elektronentransportschicht Wolfram-Paddlewheel [W₂(hpp)₄] mit hpp = 1,3,4,6,7,8-Hexahydro-2H-pyrimido-[1,2-a]-pyrimidin ist.

13. Licht emittierendes Bauelement nach einem der Ansprüche 1 bis 12, **dadurch gekennzeichnet, dass** die dotierte Molekülschicht eine Leitfähigkeit im einem Bereich von 1E-7 S/cm bis 1E-3S/cm aufweist.

14. Licht emittierendes Bauelement nach einem der Ansprüche 1 bis 13, **dadurch gekennzeichnet, dass** die dotierte Molekülschicht eine Leitfähigkeit im einem Bereich von 1E-6S/cm bis 5E-5S/cm aufweist.

15. Licht emittierendes Bauelement nach Anspruch 5 oder einem der Ansprüche 6 bis 14, soweit auf Anspruch 5 rückbezogen, **dadurch gekennzeichnet, dass** die Leitfähigkeit der undotierten Zwischenschicht wenigstens eine halbe Größenordnung geringer als die Leitfähigkeit der dotierten Molekülschicht ist.

16. Licht emittierendes Bauelement nach einem der Ansprüche 1 bis 15, **dadurch gekennzeichnet, dass** die dotierte Molekülschicht eine Dicke in einem Bereich von 40 nm bis 500 nm aufweist.

17. Licht emittierendes Bauelement nach einem der Ansprüche 1 bis 16, **dadurch gekennzeichnet, dass** die dotierte Molekülschicht eine Dicke in einem Bereich von 50 nm bis 300 nm aufweist.

18. Licht emittierendes Bauelement nach nach Anspruch 5 oder einem der Ansprüche 6 bis 17, soweit auf Anspruch 5 rückbezogen, **dadurch gekennzeichnet, dass** die undotierte Zwischenschicht eine Dicke in einem Bereich von 2 nm und 30 nm aufweist.

19. Licht emittierendes Bauelement nach nach Anspruch 5 oder einem der Ansprüche 6 bis 18, soweit auf Anspruch 5 rückbezogen, **dadurch gekennzeichnet, dass** die undotierte Zwischenschicht eine Dicke in einem Bereich von 5 nm und 15 nm aufweist.

20. Licht emittierendes Bauelement nach Anspruch 5 oder einem der Ansprüche 6 bis 19, soweit auf Anspruch 5 rückbezogen, **dadurch gekennzeichnet, dass** die undotierte Zwischenschicht dünner als die dotierte Molekülschicht ausgebildet ist.

21. Licht emittierendes Bauelement nach einem der Ansprüche 1 bis 20 , **dadurch gekennzeichnet, dass** die Dotanden-Konzentration zwischen 1:1000 und 1:20 beträgt.

22. Verfahren zur Herstellung eines Licht emittierenden Bauelementes nach einem der Ansprüche 1 bis 21, bei dem auf ein Substrat ein Grundkontakt, danach mehrere Schichten und schließlich ein Deckkontakt aufgebracht werden, wobei mindestens eine der Schichten als Polymerschicht aufgetragen und mehrere der Schichten als Molekülschichten aufgedampft werden, und wobei eine der Molekülschichten dotiert wird, wobei der Deckkontakt (7) als eine Kathode und eine dem Deckkontakt (7) nächstliegende Schicht als eine Elektronen transportierende und mit einem organischen n-dotierte Molekülschicht gebildet werden, wobei die n-dotierte Molekülschicht mit einer ein Matrixmaterial bildenden, organischen Hauptsubstanz und dem Donatormaterial gebildet wird, **dadurch gekennzeichnet, dass** das Donatormaterial ein Ionisationspotential von kleiner als 4,1 eV hat und eine molekulare Masse von größer 200 g/mol aufweist.

23. Verfahren nach Anspruch 22, dass die Dotierung der Molekülschicht in einem Vakuum aus zwei separat geregelten Quellen als eine Mischverdampfung erfolgt.

24. Verfahren nach Anspruch 22 oder 23, **dadurch gekennzeichnet, dass** die Dotanden-Konzentration zwischen 1:1000 und 1:20 liegt.

25. Verfahren nach einem der Ansprüche 22 bis 24, **dadurch gekennzeichnet, dass** der Auftrag der Polymerschicht nach dem Prinzip eines Tintenstrahldruckes (Ink-Jet Printing) erfolgt.

26. Verfahren nach Anspruch 25, **dadurch gekennzeichnet, dass** die Emissionsschicht (4) zur Herstellung einer Multicolor-OLED lateral durch Ink-Jet Printing derart strukturiert wird, dass rote, grüne und blaue Pixel nebeneinander entstehen.

27. Verfahren nach einem der Ansprüche 22 bis 26, **dadurch gekennzeichnet, dass** die Dicke aller Schichten im Bereich 0.1 nm bis 1 µm liegt.

28. Verfahren nach einem der Ansprüche 22 bis 27, **dadurch gekennzeichnet, dass** zumindest eine der Molekülschichten durch Aufbringen einer gemischten Schicht aus einer Lösung oder durch Hintereinanderaufbringen der Materialien mit anschließender Diffusion der Dotanden in die Molekülschicht hergestellt und dotiert wird.

29. Verfahren nach einem der Ansprüche 22 bis 28, **dadurch gekennzeichnet, dass** in der Elektronentransportschicht als Donator-Dotand Wolfram-Paddlewheel [W₂(hpp)₄] mit hpp = 1,3,4,6,7,8-Hexahydro-2H-pyrimido-[1,2-a]-pyrimidin verwendet wird.

## Claims

1. A light emitting component with organic layers consisting of a plurality of layers between a bottom contact on a substrate and a top contact, with polymer layers from a polymer and with molecular layers from small molecules applied in a vacuum, wherein at least one polymer layer (3; 4) and two molecular layers (5; 6) are arranged, wherein
- the top contact (7) is a cathode and the layer nearest the top contact (7) is configured as an electron-transporting molecular layer n-doped with an organic donor material, wherein the n-doped molecular layer comprises an organic main substance forming a matrix material and the donor material, **characterised in that** the donor material has an ionisation potential of less than 4.1eV and the molecular mass of the donor material is larger than 200g/mol.

2. The light-emitting component according to claim 1, **characterised in that** a polymer layer is arranged simultaneously forming an emitter layer and a transport layer.

3. The light-emitting component according to claim 1 or 2, **characterised in that** more than two polymer layers are arranged.

4. The light-emitting component according to one of claims 1 to 3, **characterised in that** only one molecular layer is arranged which is doped.

5. The light-emitting component according to one of claims 1 to 3, **characterised in that** the matrix material of the doped molecular layer (9) is equal to a matrix material of an undoped intermediate layer (5).

6. The light-emitting component according to one of claims 1 to 5, **characterised in that** one or more doped or undoped molecular layers are arranged on the bottom contact (2) and one more polymer layers are arranged on the side facing away from the bottom contact.

7. The light-emitting component according to one of claims 1 or 2, **characterised in that** a polymer layer is arranged, adjacent to which a molecular layer is arranged both on the side facing the bottom contact (2) and on the side facing the top contact (7).

8. The light-emitting component according to one of claims 1 to 7, **characterised in that** the top contact (7) and the bottom contact (2) are transparent.

9. The light-emitting component according to one of claims 1 to 8, **characterised in that** it consists of a multiple arrangement of identical light-emitting components which are electrically connected with each other by means of a connecting layer.

10. The light-emitting component according to claim 9, **characterised in that** the connecting layer is provided with a contact and can be activated via the same.

11. The light-emitting component according to claim 9 or 10, **characterised in that** the connecting layer and/or the contact are transparent.

12. The light-emitting component according to one of claims 1 to 11, **characterised in that** the donor doping agent in the electron transporting layer is Wolfram-Paddlewheel [W2(hpp)4] with hpp = 1,3,4,6,7,8-hexahydro-2H-pyrimido-[1,2-a]-pyrimidin.

13. The light-emitting component according to one of claims 1 to 12, **characterised in that** the doped molecular layer has a conductivity from 1E-7S/cm to 1E-3S/cm.

14. The light-emitting component according to one of claims 1 to 12, **characterised in that** the doped molecular layer has a conductivity from 1E-6S/cm to 1E-5S/cm.

15. The light-emitting component according to claim 5 or one of claims 6 to 14 insofar as referred back to claim 5, **characterised in that** the conductivity of the undoped intermediate layer is less by at least half a magnitude than the conductivity of the doped molecular layer.

16. The light-emitting component according to one of claims 1 to 15, **characterised in that** the doped molecular layer has a thickness from 40 nm to 500 nm.

17. The light-emitting component according to one of claims 1 to 15, **characterised in that** the doped molecular layer has a thickness from 50 nm to 300 nm.

18. The light-emitting component according to claim 5 or one of claims 6 to 17 insofar as referred back to claim 5, **characterised in that** the undoped intermediate layer has a thickness from 2 nm to 30 nm.

19. The light-emitting component according to claim 5 or one of claims 6 to 18 insofar as referred back to claim 5, **characterised in that** the undoped intermediate layer has a thickness from 5 nm to 15 nm.

20. The light-emitting component according to claim 5 or one of claims 6 to 19 insofar as referred back to claim 5, **characterised in that** the undoped intermediate layer is thinner than the doped molecular layer.

21. The light-emitting component according to one of claims 1 to 20, **characterised in that** the concentration of the doping agent lies between 1:1000 and 1:20.

22. A method for manufacturing a light emitting component according to one of claims 1 to 21, where a bottom contact is applied to a substrate followed by several layers and finally a top contact is applied, wherein at least one of the layers is applied as a polymer layer and several of the layers are applied as molecular layers, and wherein one of the molecular layers is doped, wherein the top contact (7) is formed as a cathode and a layer nearest the top contact (7) is formed as an electron-transporting organic n-doped molecular layer, wherein the n-doped molecular layer is formed with an organic main substance forming a matrix material and the donor material, **characterised in that** the donor material comprises an ionisation potential of less than 4.1eV and a molecular mass of larger than 200 g/mol.

23. The method according to claim 22, **characterised in that** doping of the molecular layer is carried out in a vacuum of two separately controlled sources as a mixed vaporisation.

24. The method according to claim 22, **characterised in that** the concentration of the doping agent is between 1:1000 and 1:20.

25. The method according to one of claims 22 to 24, **characterised in that** application of the polymer layer is carried out according to the principle of inkjet printing.

26. The method according to claim 25, **characterised in that** the emission layer (4) for manufacturing a multi-colour OLED is structured laterally by means of inkjet printing such that red, green and blue pixels are formed next to each other.

27. The method according to one of claims 22 to 26, **characterised in that** the thickness of all layers is from 0.1 nm to 1 µm.

28. The method according to one of claims 22 to 27, **characterised in that** at least one of the molecular layers is manufactured and doped by applying a mixed layer from a solution or by sequentially applying the materials with subsequent diffusion of the doping agents into the molecular layer.

29. The method according to one of claims 22 to 28, **characterised in that** in the electron transporting layer the donor doping agent used is Wolfram-Paddlewheel [W2(hpp)4] with hpp = 1,3,4,6,7,8-hexahydro-2H-pyrimido-[1,2-a]-pyrimidin.

## Revendications

1. Composant émettant de la lumière avec des couches organiques, constitué de plusieurs couches entre un contact de base sur un substrat et un contact de recouvrement, avec des couches polymères en un polymère et avec des couches moléculaires en molécules appliquées sous vide, au moins une couche polymère (3 ; 4) et deux couches moléculaires (5 ; 6) étant placées,
- le contact de recouvrement (7) étant une cathode et la couche la plus proche dans le contact de recouvrement (7) étant conçue en tant que couche moléculaire transportant des électrons et étant n-dopée avec une matière donatrice organique, le couche moléculaire n-dopée comprenant une substance principale organique formant une matière matricielle et la matière donatrice, **caractérisé en ce que** la matière donatrice dispose d'un potentiel d'ionisation inférieur à 4,1 eV et la masse moléculaire de la matière donatrice est supérieure à 200 g/mole.

2. Composant émettant de la lumière selon la revendication 1, **caractérisé en ce qu'**une couche polymère est placée qui forme simultanément une couche émettrice et une couche de transport.

3. Composant émettant de la lumière selon la revendication 1 ou la revendication 2, **caractérisé en ce que** plus de deux couches polymères (3 ; 4) sont placées.

4. Composant émettant de la lumière selon l'une quelconque des revendications 1 à 3, **caractérisé en ce qu'**une seule couche moléculaire est placée, qui est dopée.

5. Composant émettant de la lumière selon l'une quelconque des revendications 1 à 3, **caractérisé en ce que** la matière matricielle de la couche moléculaire (9) dopée est identique à une matière matricielle d'une couche intermédiaire (5) non dopée.

6. Composant émettant de la lumière selon l'une quelconque des revendications 1 à 5, **caractérisé en ce que** sur le contact de base (2) sont placées une ou plusieurs couches moléculaires dopées ou non dopées et sur sa face opposée au contact de base (2) sont placées une ou plusieurs couches moléculaires.

7. Composant émettant de la lumière selon l'une quelconque des revendications 1 ou 2, **caractérisé en ce qu'**il est placé une couche polymère sur laquelle chaque fois une couche moléculaire est adjacente aussi bien à sa face dirigée vers le contact de base (2) qu'également à sa face dirigée vers le contact de recouvrement (7).

8. Composant émettant de la lumière selon l'une quelconque des revendications 1 à 7, **caractérisé en ce que** le contact de recouvrement (7) et le contact de base (2) sont conçus en étant transparents.

9. Composant émettant de la lumière selon l'une quelconque des revendications 1 à 8, **caractérisé en ce qu'**il est constitué d'un agencement multiple de composants identiques émettant de la lumière qui sont électriquement assemblés les uns avec les autres à l'aide d'une couche d'assemblage.

10. Composant émettant de la lumière selon la revendication 9, **caractérisé en ce que** la couche d'assemblage est munie d'un contact ou est activable par l'intermédiaire de celui-ci.

11. Composant émettant de la lumière selon la revendication 9 ou la revendication 10, **caractérisé en ce que** la couche d'assemblage et/ou le contact sont conçus en étant transparents.

12. Composant émettant de la lumière selon l'une quelconque des revendications 1 à 11, **caractérisé en ce que** l'agent de dopage donneur dans la couche de transport d'électrons est du paddlewheel de tungstène [W2(hpp)4] avec hpp = 1, 3, 4, 6, 7, 8-hexahydro-2H-pyrimido-[1,2-a-]-pyrimidine.

13. Composant émettant de la lumière selon l'une quelconque des revendications 1 à 12, **caractérisé en ce que** la couche moléculaire dopée fait preuve d'une conductibilité dans un ordre de 1E-7S/cm à 1E-3S/cm.

14. Composant émettant de la lumière selon l'une quelconque des revendications 1 à 13, **caractérisé en ce que** la couche moléculaire dopée fait preuve d'une conductibilité dans un ordre de 1E-6S/cm à 5E/5S/cm.

15. Composant émettant de la lumière selon la revendication 5 ou selon l'une quelconque des revendications 6 à 14, si elles se réfèrent à la revendication 5, **caractérisé en ce que** la conductibilité de la couche intermédiaire non dopée est inférieure d'au moins un demi ordre de grandeur à la conductibilité de la couche moléculaire dopée.

16. Composant émettant de la lumière selon l'une quelconque des revendications 1 à 15, **caractérisé en ce que** la couche moléculaire dopée présente une épaisseur dans un ordre de 40 nm à 500 nm.

17. Composant émettant de la lumière selon l'une quelconque des revendications 1 à 16, **caractérisé en ce que** la couche moléculaire dopée présente une épaisseur dans un ordre de 50 nm à 300 nm.

18. Composant émettant de la lumière selon la revendication 5 ou selon l'une quelconque des revendications 6 à 17, si elles se réfèrent à la revendication 5, **caractérisé en ce que** la couche intermédiaire non dopée présente une épaisseur dans un ordre de 2 nm et 30 nm.

19. Composant émettant de la lumière selon la revendication 5 ou selon l'une quelconque des revendications 6 à 18, si elles se réfèrent à la revendication 5, **caractérisé en ce que** la couche intermédiaire non dopée présente une épaisseur dans un ordre de 5 nm et 15 nm.

20. Composant émettant de la lumière selon la revendication 5 ou selon l'une quelconque des revendications 6 à 19, si elles se réfèrent à la revendication 5, caractérisé en ce la couche intermédiaire non dopée est conçue en étant plus mince que la couche moléculaire dopée.

21. Composant émettant de la lumière selon l'une quelconque des revendications 1 à 20, **caractérisé en ce que** la concentration d'agents dopants se situe entre 1 : 1000 et 1 : 20.

22. Procédé destiné à la fabrication d'un composant émettant une lumière selon l'une quelconque des revendications 1 à 21, lors duquel sur un substrat, on applique un contact de base, ensuite plusieurs couches et finalement un contact de recouvrement, au moins l'une des couches étant appliquée en tant que couche polymère et plusieurs des couches étant vaporisées en tant que couche moléculaires et l'une des couches moléculaires étant dopée, le contact de recouvrement (7) étant conçu en tant qu'une cathode et une couche la plus proche du contact de recouvrement (7) étant conçue en tant qu'une couche moléculaire transportant des électrons et dopée d'un n organique, la couche moléculaire n-dopée étant formée d'une substance principale organique, formant une matière matricielle et de la matière donatrice, **caractérisé en ce que** la matière donatrice dispose d'un potentiel d'ionisation inférieur à 4,1 eV et comporte une masse moléculaire supérieure à 200 g/mole.

23. Procédé selon la revendication 22, **caractérisé en ce que** le dopage de la couche moléculaire s'effectue sous un vide à partir de deux sources à réglage séparé, sous la forme d'une vaporisation mixte.

24. Procédé selon la revendication 22 ou la revendication 23, **caractérisé en ce que** la concentration d'agents dopants se situe entre 1 : 1000 et 1 : 20.

25. Procédé selon l'une quelconque des revendications 22 à 24, **caractérisé en ce que** l'application de la couche polymère s'effectue selon le principe d'une impression au jet d'encre (Ink-Jet-Printing).

26. Procédé selon la revendication 25, **caractérisé en ce que** pour la création d'une OLED multicolore, on structure latéralement la couche émettrice (4) par Ink-Jet-Printing, de telle sorte que des pixels rouges, verts et bleus prennent naissance côte à côte.

27. Procédé selon l'une quelconque des revendications 22 à 26, **caractérisé en ce que** l'épaisseur de toutes les couches se situe dans un ordre de 0.1 nm à 1 µm.

28. Procédé selon l'une quelconque des revendications 22 à 27, **caractérisé en ce qu'**on créé et on dope au moins l'une des couches moléculaires par application d'une couche mixte d'une solution ou par application successive des matières avec diffusion consécutive des agents dopants dans la couche moléculaire

29. Procédé selon l'une quelconque des revendications 22 à 28, **caractérisé en ce que** dans la couche de transport des électrons, on utilise en tant qu'agent de dopage donneur du paddlewheel de tungstène [W₂(hpp)₄] avec hpp = 1, 3, 4, 6, 7, 8-hexahydro-2H-pyrïmido-[1, 2-a-]-pyrimidine.
